# EUROPEAN PATENT APPLICATION

(11) **EP 4 250 035 A1**
(43) Date of publication of application: **27.09.2023**
(21) Application number: 22164081.6
(22) Date of filing: 24.03.2022
(51) Int. Cl.: G05B 23/02, G01R 31/34, B64D 45/00

(54) **SYSTEM AND METHOD FOR MACHINE DIAGNOSIS**

(71) Applicant: Rolls-Royce Deutschland Ltd & Co KG, 15827 Blankenfelde-Mahlow (DE)
(72) Inventor: CICIRIELLO, Lucia, 15827 Blankenfelde-Mahlow (DE); BAUER, Dr.-Ing. Johannes Gabriel, 15827 Blankenfelde-Mahlow (DE)
(74) Representative: Maikowski & Ninnemann Patentanwälte Partnerschaft mbB

(57) **Abstract**

A system (1A-1E), comprises: a machine (10A-10E) operable in a defined condition described by at least one operating parameter; a controller (11) adapted to control at least one actuator (101, 102, 14) so as to exert an excitation of at least a part of the system (1A-1E), in particular of the machine (10A-10E), and/or to detect a predetermined excitation of at least a part of the system (1A-1E), in particular of the machine (10A-10E), the excitation being superimposed to the defined condition 10A-10E); at least one sensor (12, 108) to measure at least one response indicator of a response of at least a part of the system (1A-1E), in particular of the machine (10A-10E), to the excitation; and a diagnosis system (13) adapted to receive the at least one measured response indicator and the at least one operating parameter.

## Description

The present disclosure relates to a system and a method for acquiring data for machine diagnosis.

In many applications, particularly in the field of power plants, engines, and drivelines, it is desirable to obtain data to perform a diagnosis of the respective machines.

Often, a characteristic signal variation necessary for diagnostics is one to three orders of magnitude lower than a normal noise/vibration level of a machine during normal operation. Thus, levels of alarms may be defined that are tailored to prevent a loss of a structural integrity, but that are much higher than useful thresholds to trigger an identification of early diagnostics, e.g., to optimize maintenance tasks. Therefore, it would be beneficial to augment a corresponding signal-to-noise ratio.

Further, an improved engine health monitoring (EHM) would be beneficial in order to be able to extrapolate meaningful indications from an identification of drifts of system status from nominal conditions also for aircrafts and powerplants that work within a cross-domain of physical mutual interactions between mechanical and electrical loads, which is basically unexplored. In order to identify an early mechanical and/or electrical degradation, the status of large arrays of aircraft systems outputs would be required to be checked in a selective way.

Due to more complex tasks required for engine or aircraft controllers, a higher number of safety-critical locations are distributed on much lighter aircrafts, and in the light of the electromechanical cross-domain, it would be beneficial if the EHM comprised tools to quantify non-linear effects and to verify the stability of the controllers, particularly within an aircraft mission envelope.

Commonly, performing diagnosis of machines is time-consuming. Further, some components can be difficult to analyze in an assembled condition. For this reason, maintenance might be necessary at relatively short intervals.

It is an object to allow improved diagnostics of machines.

According to an aspect there is provided a system comprising a machine being operable in a defined condition described by at least one operating parameter; a controller adapted to control at least one actuator (which may be part of the system or external to it) so as to exert an excitation of the machine and/or to detect a predetermined excitation of the machine, the excitation being superimposed to the defined condition of the machine; at least one sensor to measure at least one response indicator of a response of the machine to the excitation; and a diagnosis system adapted to receive the at least one measured response indicator and the at least one operating parameter.

This allows to perform a diagnosis of the machine using the at least one measured response indicator and the at least one operating parameter in various defined conditions, such as stand still or a nominal operation. In the case of an aircraft engine, the defined condition may be a takeoff, cruise or landing, or a power-off or ground condition. For example, acquiring diagnostics data of an engine during a flight of an airplane can increase safety and reduce maintenance times on the ground, e.g., verifying a state of an aircraft and of powerplant systems, e.g., at all relevant aircraft speeds, powers, power shares, attitudes, attitudes, external temperatures (e.g., rated take-off power in hot days etc.).

According to an aspect there is provided a system comprising a machine; a controller adapted to control at least one actuator so as to exert an excitation of the machine and/or to detect an excitation, particularly a predetermined excitation, of the machine; at least one sensor to measure at least one response indicator of a response of the machine to the excitation; and a diagnosis system adapted to receive the at least one measured response indicator. The diagnosis system may perform a diagnosis of the machine based on the response indicator.

The system may further comprise a device providing a phase reference, commonly referred to as keyphasor. The diagnosis system may be adapted to determine a phase of the measured response indicator with respect to the phase reference. It is worth noting that the phase reference can be a fixed physical phase reference tagged on a rotor, or the phase angle may be measured with respect to a harmonic signal, which may be sampled synchronously to the analyzed signal. Optionally, the diagnosis system is further adapted to determine a phase shift between the phase of the measured response indicator with respect to the phase reference, and a baseline. The baseline may be the phase of a measured response indicator with respect to a corresponding phase reference in the system at a different time (this is a particularly relevant case for an early crack detection by detecting a shift in the modal deformation of a rotor; for example, not an initial phase angle itself may be the indicator of the state of a rotor, e.g. a disc, but the angular shift in the position of a rotating zero displacement of the area being monitored), or in another system, e.g., an equally designed system. In particular, the baseline may correspond to the same or similar defined condition, e.g., described by one or more approximately equal operating parameters. This allows to detect even small defects, as other sources of variations can be widely excluded. A change of a phase shift can be a very significant early indicator, e.g., for a crack or other faults in a component. Optionally, a phase analysis is executed with respect to a harmonic modulation frequency (e.g., phase lag).

The diagnosis system may be adapted to combine the at least one measured response indicator and the at least one operating parameter into a state vector. Optionally, the diagnosis system is adapted to compare the state vector with another state vector acquired at a different time and/or system. The state vector may comprise derivatives and/or gradients of one or more operating parameters and/or one or more response indicators. The operating parameters may be or comprise target values and/or measured values. The state vector allows a thorough analysis and comparison of the response of the machine. Notably, the response may include a measured level of the actual excitation, as generated by the at least one actuator. Alternatively, or in addition, the state vector may include an indication of the target excitation.

The system may comprise one or a plurality of sensors to measure response indicators. The diagnosis system may be adapted to determine which one or more of the response indicators varies (e.g., over time) in response to the superimposed excitation. This allows an early detection of faults. For example, the selected excitations have the purpose to magnify and filter out a parameter variation that has been selected for diagnostics, e.g., isolating it from the whole system response, which may include a characteristic feature of the controllers. This feature may be characteristic of a multi-input-multi-output system and it may be based on FEM calculations, such as the calculation of influence coefficients and simulation of defects (e.g., a modal stiffness variation can be related to a deterioration of a flexible element, or a loss of tightening torque in a flanged connections etc.).

Optionally, the system comprises a plurality of sensors at different locations of the machine. Therein, the diagnosis system may be adapted to calculate a ratio of the response indicators measured by means of sensors at different locations. The response indicators may be single values, spectra, distributions, matrices or the like.

The diagnosis system may be adapted to determine covariances of one or more response and/or excitation indicators and one or more operating parameters to perform a diagnosis of the system. Detecting such covariances allows to locate defects. For example, if response indicators, e.g., vibration amplitudes, at two adjacent sensor locations increase at the same time, a fault might be present in that area. In general, the diagnosis system may be adapted to determine one or more correlations between one or more response indicators and one or more operating parameters, to perform a diagnosis of the system. For example, the diagnosis system may be adapted to determine correlations between one or more response indicators and a plurality of operating parameters.

Optionally, the diagnosis system comprises an artificial intelligence module to determine one or more correlations in one or more response indicators and one or more operating parameters to perform a diagnosis of the system. Such an artificial intelligence module can detect correlations that are not known a priori (e.g., because not yet disclosed by analytics or models), in large amounts of data. The detection of contemporarily variations of mechanical and electrical parameters and their correlations at certain system conditions allows to analyze more thoroughly failure modes. Upon the correlations, the EHM can be designed to monitor the group of parameters that are identified to be the precursors of an incipient failure mode, increasing the effectiveness and reducing the costs.

Optionally, the diagnosis system is adapted to determine a vibration (more generally, a status of the system, e.g. a temperature, current shifts etc.), and to provide a command to the controller so as to control at least one actuator to exert an excitation of the machine based on the determined vibration (and/or to determine a position of a centerline of a shaft of the machine). Thus, the system may actively mistune vibrations (for instance, at static and/or rotating interfaces between one or more power generators and an aircraft) using the actuator. For example, the actuators may exert controlled time-variable forces and/or moments to mistune vibration and/or control clearances. These forces and moments can be calculated from an FEM analysis or look-up table or be based on the measured vibration.

The controller may be adapted to control the at least one actuator so as to exert an excitation of the machine, the excitation being periodical, an impulse (e.g., a single impulse), a sweep or a rectangular function. Therein, the diagnosis system may be adapted store a type (e.g., periodical, impulse, sweep or rectangular) of the excitation of the machine together with the measured excitation and at least one measured response indicator and the at least one operating parameter in a memory. The controller may be adapted to selectively exert one of a predefined plurality of excitations. Different excitations may be particularly suitable to detect certain defects in various components. The diagnosis system may be adapted to store a real level, frequency and/or phase of the exerted excitation (e.g., additionally), so that a transfer function can be calculated. Optionally, operating parameters and response indicators are not distinguished in the state vector and they may undergo the same analysis, e.g., covariance algorithm.

The at least one measured response indicator may be or comprise an electrical parameter, e.g., of power electronics, of the controller and/or of another control unit, of the machine. Indeed, exerting a mechanic excitation on the machine can induce an electric response in the electrical components of the machine. Thus, even a diagnose of such electrical components is possible with the system.

The diagnosis system may further be adapted to determine a ratio of a response indicator (e.g., the at least one response indicator) and the excitation (e.g., respective amplitudes) in a frequency domain. This allows to particularly precisely locate potential defects in components of the machine.

Optionally, the actuator is configured to generate non-contact forces and/or moments (e.g., in X, Y and Z directions; for instance, to simulate a load path at interfaces of the system) on the machine to exert the excitation, e.g., electromagnetic forces. The actuator may be a dedicated device. Additionally, or alternatively, an electric motor and/or generator of the machine and/or a magnetic bearing of the machine may be used as the actuator. This allows a self-diagnose of the machine without additional active means. Notably, an excitation is conceivable in which the actuator produces a force and/or a moment, for instance to generate a variable non-contact modal stiffness to reduce vibration and related noise, or to control clearances (e.g., tip clearances, journal bearing clearances etc.).

The at least one sensor may comprise a proximity probe, an accelerometer or a strain gauge. Alternatively, or in addition, the machine comprises an electric motor and/or generator having a plurality of coils. Optionally, the at least one sensor is adapted to receive signals indicative for and/or based on differences among voltages and/or electrical currents of the plurality of coils, and, optionally, to determine a vibration of a shaft of the machine using the signals. This allows to use the electric motor/generator as a sensor probe (i.e., function as an embedded sensor). This allows a particularly high precision of the measurement and, at the same time, a measurement without additional mechanical sensor. Notably, if such an embedded sensor has been calibrated and a range defined, it may not be necessary to have other external sensors, as it could work alone, without necessity of a cross-calibration with a conventional sensor. For example, a possible configuration (with instrumentation cost minimization) may comprise an electrical machine and a an embedded displacement sensor to measure shaft movements.

The system may further comprise or be an aircraft. Therein, the machine may be an engine of the aircraft (and/or its control systems). Optionally, the detected predetermined excitation of the machine is a cross wind or another external influence on the aircraft (or in general, on the system in applications where the system is not (part of) an aircraft). The one or more possible external influences might be predefined. Thus, the machine does not even have to comprise an actuator. The system can be particularly beneficial in use with an aircraft. Notably, the excitations and the responses could be applied and measured in any location of the whole system (e.g., aircraft), including controllers, movable surfaces, on-board accessories and services etc. Electrical machines and power plants usually have many actuators and relevant instrumented locations where to extract mechanical and electrical quantities for diagnostic purpose.

The system may comprise an alignment system for aligning and fixedly mounting the machine on the ground. This allows to bring the machine in a precisely defined position with respect to another device under test. By this, the machine can be used to perform one or more pre-defined tests by exerting the one or more excitations as described above to perform a diagnose of the device under test. A flexible coupling may be operatively connected with an electrical machine. Other couplings are possible. They may be a combination of flexible coupling elements, belt, clutch, hydrodynamic actuator and/or transmission, to allow a transmission of speed and torque in series and parallel hybrid electrical powerplants. The one or more couplings may particularly be rotor-to-rotor interfaces, which simulate a load path, and allow to measure outputs and finally may reduce transmitted modulations using for instance a controlled variation of a non-contact stiffness as applied at one of the actuator close to its location.

According to an aspect, a method is provided. The method comprises operating a machine in a defined condition described by at least one operating parameter; controlling at least one actuator so as to exert an excitation of the machine and/or to detect a predetermined excitation of the machine, the excitation being superimposed to the defined condition of the machine; measuring, by means of at least one sensor, at least one response indicator of a response of the machine to the excitation; and receiving, by a diagnosis system, the at least one measured response indicator and the at least one operating parameter. The method may use the system of any aspect or embodiment described herein.

According to an aspect, a method is provided. The method comprises controlling at least one actuator so as to exert an excitation of a machine and/or to detect an excitation, e.g., a predetermined excitation, of the machine; measuring, by means of at least one sensor, at least one response indicator of a response of the machine to the excitation; and receiving, by a diagnosis system, the at least one measured response indicator. The method may use the system of any aspect or embodiment described herein.

According to a further aspect, a computer-readable storage medium is provided that stores instructions which, when executed by one or more processors (e.g., of the diagnosis system), cause the one or more processors to perform the methods described above and herein.

Embodiments will now be described by way of example only, with reference to the schematic Figures, in which:
- Figures 1-3: are different views of an aircraft having a system with plurality of machines;
- Figure 4: is a view of a system for an aircraft having a plurality of machines;
- Figure 5: is a view of a system having one machine with several actuators and sensors;
- Figure 6: is a view of the arrangement of a plurality of sensors of the system of Figure 5;
- Figures 7A-7G: are diagrams illustrating various excitations to be exerted on a system;
- Figure 8: is a diagram illustrating a position of the center of a shaft of the machine of Figure 4;
- Figure 9: a diagram showing frequency spectra and illustrating an identification of natural frequencies and resonances with a harmonic source of excitation;
- Figure 10: shows an arrangement of sensors for a phase shift measurement;
- Figure 11: shows diagrams of a frequency analysis versus time;
- Figure 12A and 12B: show different mode shapes of a rotatable element;
- Figure 13A and 13B: illustrate the effect of a crack or of an initiation of a crack in the rotatable element to the modal stiffness and the mode shape;
- Figure 14: shows coils of an electric motor that may be used as a sensor and as an actuator;
- Figure 15: shows a system with one machine for testing external machinery;
- Figure 16: shows a system with two machines for testing external machinery, wherein a grid of locations is defined in the system, wherein the grid defines a coordinate system of excitation points, output measure points, interface simulation points, to target a certain level of transmitted vibration, the grid including inputs and outputs of controllers;
- Figure 17: shows a system similar to the system of Figure 16, wherein an additional support to simulate interface connections between modules and corresponding load paths between a housing, static bearing supports and rotors is shown and numerous sensors and mechanical and electrical interfaces between modules and between modules and rig or aircraft frame are arranged on the grid;
- Figure 18: shows a method of operating a system;
- Figures 19 to 23: illustrate different actuators; and
- Figures 24 to 26: are views of systems illustrating load paths and grid nodes.

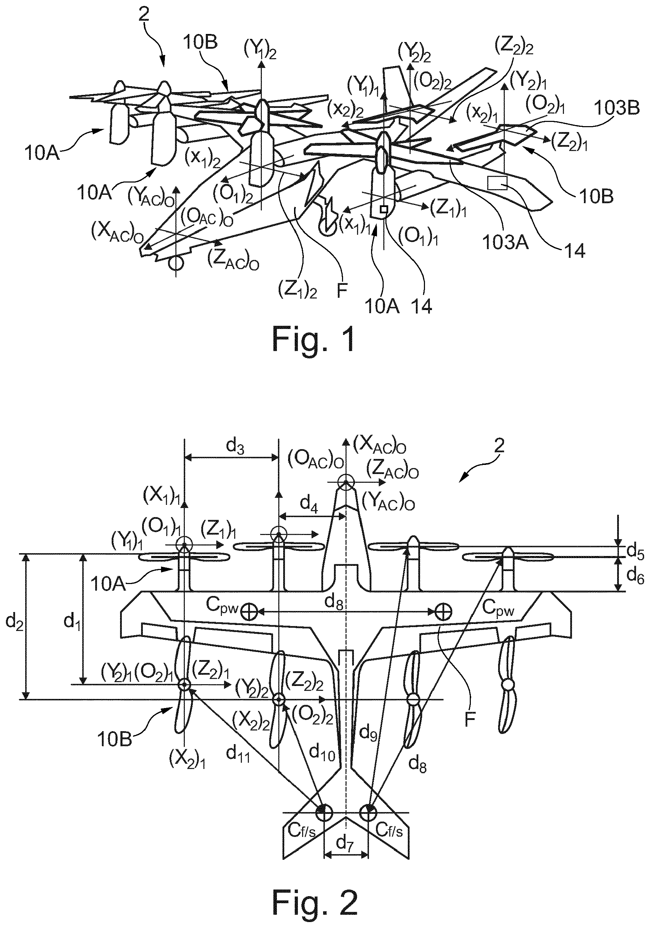

Figure 1 shows a perspective view of an aircraft 2 in the form of a vertical takeoff and landing (VTOL) aircraft. The aircraft 2 comprises a cabin, wings and a plurality of machines 10A, 10B. The structure of the aircraft 2 that mechanically connects the machines 10A, 10B (and also the other parts of the aircraft 2) with one another is referred to as the frame F of the aircraft 2.

Each of the machines 10A, 10B comprises a propeller 103A, 103B (or, more general, a turbomachine). The aircraft 2 has a plurality of (four) front machines 10A, each of which driving a propeller 103A that may be pivoted so as to selectively provide thrust in a (predominantly) vertical direction, or in a (predominantly) horizontal direction. Further, the aircraft 2 comprises a plurality of (four) rear machines 10B, each of which driving a propeller 103B that has a fixed orientation of the propeller rotational axis with respect to the frame F. The latter propellers 103B are oriented so as to provide vertical thrust.

The aircraft 2 further comprises a plurality of actuators 14 at different locations of the frame F.

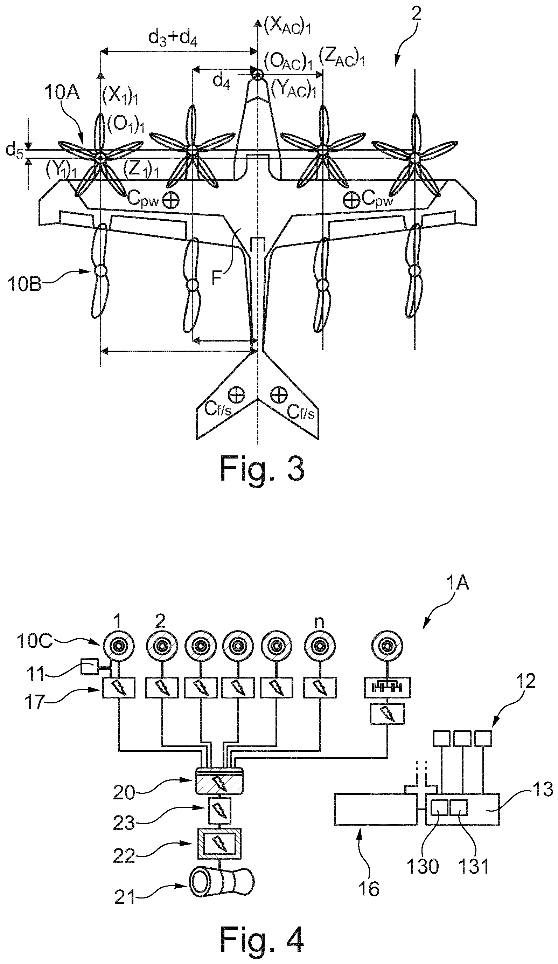

Figures 2 and 3 each show a view on the top of the aircraft 2, wherein in Figure 2 the front machines 10A are oriented so as to provide horizontal thrust, whereas in Figure 3 the front machines 10A are oriented so as to provide vertical thrust.

Figures 1-3 indicate various points O indicated with different indices, and corresponding coordinate systems with origins at these points O. Further points C indicated with different indices are shown on the wings and on rear fins of the aircraft 2, because they represent points of applications of AC forces and moments that are added to the trust and moment locations to verify the stability of the dynamic equilibrium of the aircraft. In the moment in which the short-lasting excitations are applied during a flight condition, the stability of the AC dynamic equilibrium needs to be reverified. Figures 1-3 show aircraft installations for a multi-input-multi-output diagnostic system as described below. In a horizontal plane, various distances d1-d11 are shown between these points O and C. These distances are fixed, but due to forces in the operation of the aircraft 2 elastic deformations of the frame F may lead to small changes in these distances d1-d11.

The aircraft 2 is comprised in a system 1A described with reference to Figure 4.

Figure 4 shows a system 1A including an aircraft (e.g., aircraft 2 according to Figures 1-3). The system 1A provides propulsion to the aircraft 2. The system 1A comprises a plurality of drivelines, each including a propeller 103A, 103B driven by a respective machine 10C here, the machines 10C are electrical machines.

Each of the machines collectively referred to with 10C is designed as one the machines 10A or 10B of the aircraft 2 of Figures 1-3. In applications in other aircrafts, the machines 10C may be designed differently, e.g., as gas turbine engines. One or more of the drivelines may comprise a gearbox as exemplarily indicated at the right of Figure 4.

An energy storage 20 (e.g., a battery) provides electrical power to the machines 10C. An optional gas turbine engine 21 drives an optional generator 22. The generator 22 provides electrical power to the energy storage 20, optionally via power electronics 23.

To be driven, each machine 10C is supplied with electrical power by means of power electronics 17. The power electronics 17 of each of the machines 10C are supplied with electrical power from the energy storage 20.

Each of the machines 10C comprises a controller 11 (one of which being shown in Figure 4). The controller 11 controls the operation of the respective machine 10C. The system 1A also comprises an overriding controller 16. The overriding controller 16 controls the operation of the controllers 11 of the machines 10C.

Vibrations in one driveline may interfere with vibrations in another driveline. Shafts connecting the electrical machines 10C with the respective propeller and the propellers are rotatable components that may perform an orbiting motion around a nominal rotational axis thereof. Further, the frame F may vibrate. Beatings between cross wing motor/engine or in the same multi-spool engine may be present. Because of the relative displacements that may take place during operations, a gap of the electrical machine can change during operations so that the performance of the aircraft may deteriorate. A self-diagnostic EHM concept may addresses primary the resolution of the causes for a loss of performance and structural integrity

When one or more of the machines 10C or the frame F develop a defect (or a deterioration of the electrical or mechanical state of the system with respect to a design point), such as a crack, the vibrational properties (or electrical or thermal properties) of these components can change. Thus, mechanic excitations of the system 1A (or of at least one machine 10C thereof) may lead to a different response of the system 1A and to any of the machines 10C or in the aircraft itself. Furthermore, mechanic excitations of the system 1A (or of at least one machine 10C thereof) can lead to movements of a rotor of the electric motors of the machines 10C. By this, mechanic excitations can induce a response in the power electronics 17, 23 of the system, and even in controllers (e.g., controllers 11) of the machines 10C, which react on such an electrical response. If has been found that not only defects (or out-of-design conditions; e.g., all parts are within tolerances but because of a loss of alignment the efficiency of the powerplant drops) in the mechanical structure of the system 1A and its components may lead to an altered response of the system 1A to the excitation, but also defects (or out-of-design conditions) in the electrical components. It has been further found that such excitations may be used to perform a diagnosis of the system 1A and/or one or more of its machines 10C.

Therefore, the system 1A comprises a controller 11. The controller 11 is adapted to control at least one actuator so as to exert an excitation of the system 1A, in particular of at least one machine 10C of the system 1A. Alternatively, or, as in the present example, in addition, the controller 11 is adapted to detect a predetermined excitation of the system 1A, in particular of the machine 10C. Therein, the excitation may be superimposed by the controller to the defined condition of the machine(s) 10C. The defined condition might be a standstill, takeoff, flight, landing or the like. The excitation might be selectively superimposed for a limited period of time using the actuator. Alternatively, the excitation might be predetermined and present per se. For example, a current ripple present in the operation of the machine(s) 10C may be used as the excitation. Further, an excitation of external effects such as a cross wind may be used.

Each of the electrical motors of the machines 10C can be used as the actuator. Further, dedicated actuators 14 mounted on the frame F and/or on one or more of the machines 10C may be used, see Figure 1 for examples of arrangements of such actuators 14. Such actuators may be piezo actuators or the like.

The overriding controller 16 is adapted to control the individual controllers 11 so as to control which excitations are exerted at what time, and, optionally, the spatial sequence of activation across different actuators distributed on the aircraft.

The system 1A further comprises (in general at least one) several sensors 12 located one the machine(s) 10C and, optionally, on other parts of the system 1A, e.g., on the frame F. The sensors 12 comprise one or more proximity probes, accelerometers and/or strain gauges. The sensors 12 are adapted to measure at least one response indicator of a response of one or more of the machines 10C and/or the system 1A to the excitation(s). The response indicator may be a single value, such as a frequency or an amplitude, or it may be a spectrum or distribution. The response indicators may indicate one or more mechanical parameters, such as force or torque, or one or more electrical parameters, such as current or voltage.

The machines 10C are operable in a defined condition described by at least one operating parameter. The at least one operating parameter may comprise velocity, speed, altitude and/or the like. The at least one operating parameter may also indicate the type of operation.

The system 1A further comprises a diagnosis system 13 adapted to receive the at least one measured response indicator and the at least one operating parameter. Based thereon, the diagnosis system 13 performs a diagnosis of the system 1A and of the machines 10C.

For this purpose, the diagnosis system 13 comprises a memory to store the measured response indicators (e.g., including a real level, frequency, phase and/or duration of the exerted excitation for calculating transfer functions, e.g., in the power electronics) and operating parameters. Specifically, the diagnosis system 13 may combine the measured response indicators and the operating parameters of one diagnosis procedure into a state vector, and to compare the state vector with another state vector acquired at a different time and/or with another system. The state vector may comprise parameters describing the excitation, parameters describing the response and parameters describing the defined condition. Potential state vector parameters are: DC current, voltage and/or power harmonics, phase current and/or voltage harmonics, phase current ripple, rotor position harmonics, auxiliary supply power and temperatures of switches, capacitors and a driver stage (of an inverter). In the state vectors also maintenance logged data and evidences can be included for detecting cross correlations.

By calculating one or more ratios of the response indicators, e.g., measured by means of sensors 12 at different locations, the diagnosis system 13 may detect deviations which might stem from a defect or from an out-of-design (or out-of-specification) condition approaching. Further, state vectors may be monitored by the diagnosis system 13 over time. A change in certain response indicators, particularly at unchanged operational parameters, may indicate a developing defect or from an out-of-design condition approaching. Also, the determination of covariances of one or more response indicators and/or one or more operating parameters by the diagnosis system 13 may reveal defects or an out-of-design (or out-of-specification) condition (state) approaching, e.g., when two indicators and/or parameters change at the same time which normally do not. However, the state vector may comprise a large number of indicators and parameters, as well as derivatives and gradients, so an analysis can be time consuming. Therefore, the diagnosis system 13 comprises an artificial intelligence module 130 (AI module 130) which employs an artificial intelligence, e.g., a machine learning algorithm. For example, the AI module 130 may comprise a neural network or a simpler smart data algorithm. The AI module 130 may find more hidden correlations between individual data points. The EHM may focus on selectively detecting and distinguishing effects of anomalies in both the mechanical and electrical systems as interacting together. The ping functionality may be used to filter and isolate the response that is being measured for diagnostic purposes. After having identified the main indicators of the combined failure modes, probabilistic previsions can be implemented in a particularly meaningful way.

Notably, the diagnosis system 13 may be adapted to receive and store the executed excitations as well. For instance, the magnitude, phase lag, frequency and/or time persistence of a harmonic current ripple may be received and stored (e.g., in the state vector). The executed real excitation can be different from the target excitation. Transfer functions may be calculated by the diagnosis system 13. The level of excitation or frequency range can be accounted for when evaluating the response, also, in the case of excitations to produce a non-linear response in one or more controllers.

Time variable excitation forces can be considered transients in many of the cases not longer than 1 to 2 seconds. However, the stability of the aircraft subjected to those excitations need to be substantiated to certify the system for flight interrogations. Orientations and locations may be provided for the evaluation of the dynamic equations' solutions stability. Controlled load factors may in turn be the results of an aircraft and power plant controller law and loop, and therefore subjected to stability condition as well.

Summarizing, the system 1A comprises a frame F (see Figures 1-3), a plurality of machines 10A-10C mounted on the frame F, each machine 10A-10C having an actuator 101, 102, 14 and being operable in a defined condition, one or more controllers 11 to control the actuators 101, 102, 14 so as to exert an excitation of each of the machines 10A-10C superimposed to the respective defined condition, at least one sensor 12, 108 to measure at least one response indicator of a response of the system 1A to the excitations of the machines 10A-10C, and a diagnosis system 13 adapted to receive the at least one measured response indicator. The maximum magnitude necessary for the excitation may be defined to be less than 5% of the maximum load (or power) capacity of the actuator and/or machine. This may be based on a calculation of the corresponding influence coefficients.

Notably, the diagnosis system 13 may be, in part or completely, mounted in the airplane 2. Further, the diagnosis system 13 may be, in part or completely, mounted at a location different from the aircraft, e.g., on the ground. In any case, the diagnosis system 13 may communicate with the sensors 12. The diagnosis system 13 may also communicate with the overriding controller 16 and/or one or more of the controllers 11. Further, a part of the diagnosis system 13 may be mounted in the airplane 2 and another part may be mounted at a location different from the aircraft, e.g., on the ground.

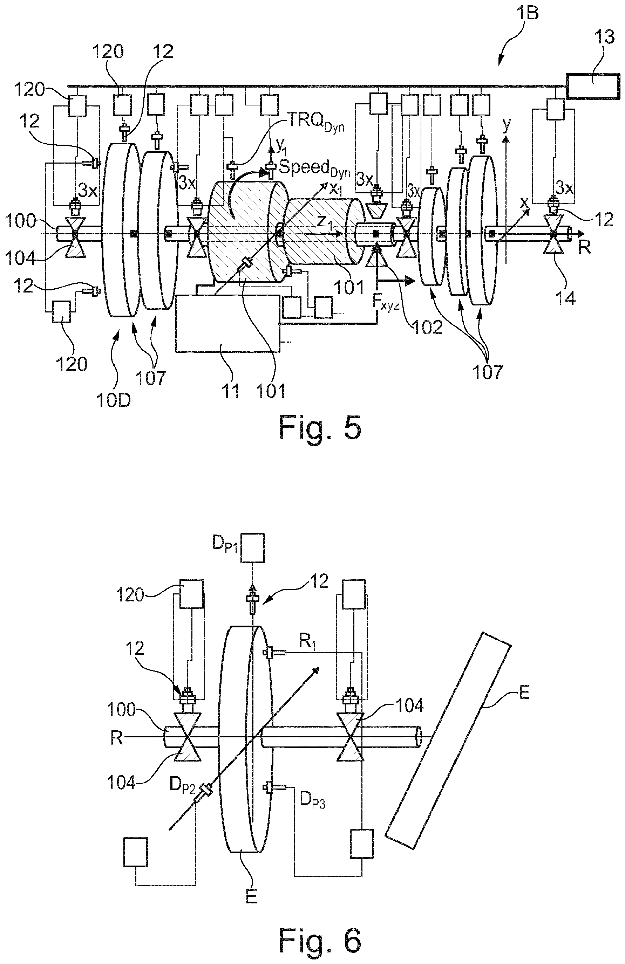

Figure 5 shows a single-machine system 1B for an aircraft. One or more of the machines 10A, 10B of the aircraft 2 of Figures 1-3 may be designed as the system 1B of Figure 5.

The system 1B comprises a (one) machine 10D. The machine 10D of the present example is an electrical machine, but a hybrid-electrical machine would also be conceivable. The machine 10D comprises a shaft 100 rotatable about a rotational axis R. The shaft is driven by at least one electric motor 101 (which particularly may be a motor-generator). In the present example, the shaft 100 is driven by two electric motors 101. In addition, the machine 10D could comprise a combustion chamber that receives air from a compressor and generates hot combustion gases that drive a turbine. In this example the shaft 100 is driven solely by the electric motors 101 as an electrical machine. Several rotating components 107 are shown which are driven by the shaft 100. These could comprise one or more propellers and/or one or more flywheels, to name some examples.

The shaft 100 is rotatably supported by bearings 104 (e.g., contact bearings). Furthermore, a magnetic bearing 102 is provided at the shaft 100. The magnetic bearing 102 may be used to support the shaft 100.

The system 1B further comprises a plurality of sensors 12. Each of the sensors 12 is connected to a corresponding data acquisition unit 120 reading the respective sensor 12 and providing sensor values and/or (e.g., preprocessed) measured response indicators to a diagnosis system 13 of the system 1B.

The sensors 12 measure axial and radial displacements of various parts of the system 1B, wherein three sensors 12 may be circumferentially distributed to exactly determine the position of the respective component. The sensors 12 of this example are proximity probes.

The electric motor 101 and the magnetic bearing 102 exert non-contact forces, more precisely, electromagnetic forces, on the shaft 100. The electric motor 101 and the magnetic bearing 102 can be used as actuators. A controller 11 of the system 1B is adapted to control the electric motor 101 and the magnetic bearing 102 so as to exert an excitation of the machine 10D. Alternatively, or in addition, the controller 11 is adapted to detect a predetermined excitation of the machine 10D, e.g., a cross wind, by means of a corresponding sensor.

The excitation is superimposed to the defined condition of the machine 10D. The defined condition may be an operating condition. The defined condition may be a steady operating condition. For example, if the machine 10D is in motion, in particular, in a constant motion, the controller may be adapted to selectively superimpose the excitation for a limited period of time. The limited period of time may be 10 seconds or less, particularly 3 seconds or less, more particularly between 1 and 2 seconds or less than 1 or less than 2 seconds, in particular when the aircraft is in flight. For tests on the ground the period of time can optionally be longer. Alternatively, the controller may control the electric motor 101 and/or the magnetic bearing 102 with current ripples or another excitation continuously. For example, the electric motor 101 may be controlled to perform the excitation in circumferential direction, i.e., to apply a dynamic torque. However, by applying asymmetrical currents to the coils of the electric machine 101, also radial forces may be applied as an excitation. Further, the controller 11 may control the magnetic bearing 102 so as to exert the excitation in radial and/or in axial direction.

The diagnosis system 13 receives the at least one measured response indicator and, optionally, the at least one operating parameter.

An excitation may be exerted in regular time intervals and/or engine cycles and/or upon operator demand.

An excitation may be exerted in tangential, radial and/or in axial direction (with respect to the nominal rotational axis R).

Figure 6 shows a section of the shaft 100 and one rotating element E fixedly mounted on the shaft 100. A first sensor 12, DP1, measures in radial direction. A second sensor 12, DP2, measures also in radial direction, but from a different position, e.g., in a direction perpendicular to the first sensor 12, DP1. A third sensor 12, DP3, measures in axial direction. These three sensors 12 are proximity probes to determine a displacement of the rotating element E. A further sensor 12, R1, is provided to measure an angle of the rotating element E with respect to the nominal rotational axis R. Such an angle is depicted in exaggerated form at the right side of Figure 6. Further sensors 12 are provided at the bearings 104. Using the sensors 12, the diagnosis system 13 (or another unit of the system 1B) can determine the position of the centerline of the shaft 100. Further, it can determine the position and orientation of the rotating element E. The sensor signals may be used as, or to determine, measured response indicators. When superimposing the excitation, a movement, vibration or the like may occur in a manner that is dependent on the existence of defects, such as a crack.

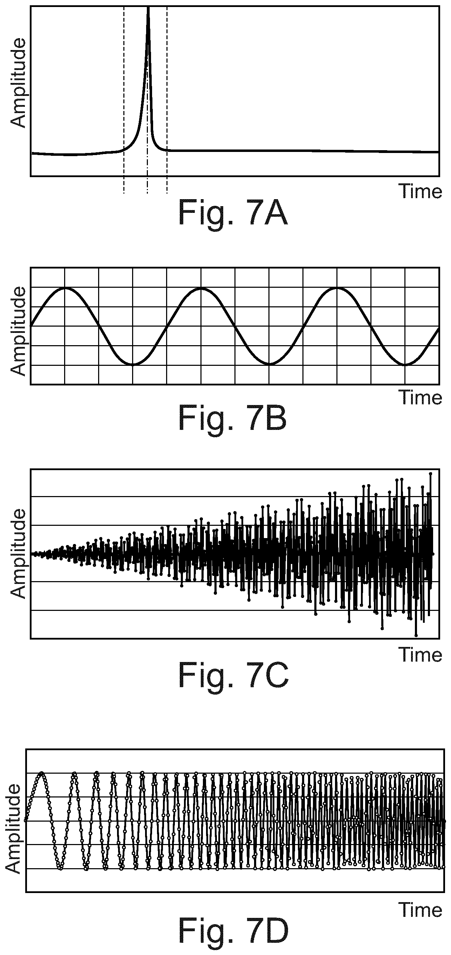

Figures 7A-7G show, in diagrams of amplitude versus time, possible excitations for superposition.

Figure 7A shows an excitation in the form of an impulse, i.e., a single peak. This excitation can be used for a broadband excitation to measure frequency response functions of rotors, the frame F. This further allows to measure, e.g., modal damping and peak phases, a variation of vibration parameters across different sensor locations and variations of magnitude ratios in x, y and z directions. For electric components, this excitation can be used to swap energy from the magnetic fields into a DC link capacitor and to check the capacity.

Figure 7B shows an excitation in the form of a periodic function, namely, a sinusoidal function, with a constant amplitude and frequency. This allows to excite specific natural frequencies, ratios between specific natural frequencies, phase variation measurements, ratios between different locations and directions. For electric components, this can be used to check a symmetry of an AC response and to detect inductance variations in the machine, e.g., due to a short circuit, faults in power switches etc.

Figure 7C shows an excitation in the form of a periodic function, namely, a sinusoidal function, with a variable amplitude and a constant frequency. This allows to excite specific natural frequencies, ratios between specific natural frequencies, phase variation measurements, ratios between different locations and directions, and modal damping variations.

Figure 7D shows an excitation in the form of a periodic function, namely, a sinusoidal function, with (at least predominantly) a constant amplitude and a variable frequency.

This is a sweep function. This also allows to excite specific natural frequencies, ratios between specific natural frequencies, phase variation measurements, ratios between different locations and directions, and modal damping variations. This also allows to monitor AC characteristics.

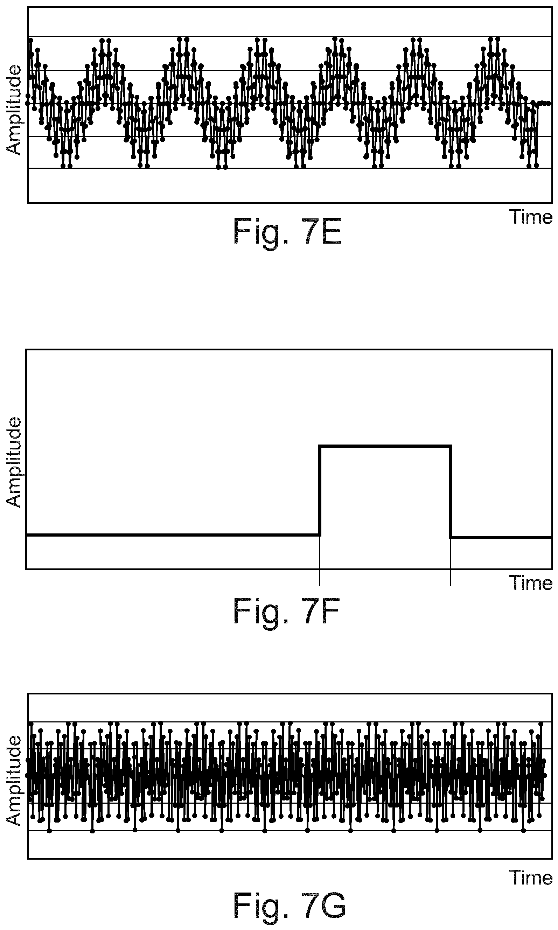

Figure 7E shows an excitation in the form of a modulation of two functions, in this example of two sinusoidal functions at different (each constant) frequencies. This allows to test the dynamic stability of the system, variations of the forced response of the system, variations of damping and a drift in the system stability.

Figure 7F shows an excitation in the form of a rectangular function. This allows to test the response to a step and at different locations.

Figure 7G shows an excitation in the form of a noise, e.g., white noise or pink noise. This excitation can be used for a broadband excitation for frequency response functions and variations over different locations and directions.

Notably, two or more of the excitations shown in Figures 7A-7G may be superimposed.

In general, an actuator of the system may be adapted to generate variable torque, and/or radial and/or axial forces, and/or capable to generate time variable, frequency variable, magnitude variable and/or phase variable moments and/or loads in a controlled manner.

In any system described herein, the controller(s) 11 and/or overriding controller 16, may be adapted to impose one or more different excitations, e.g., the excitations described above, selectively, and/or the same or different excitations at the same time using more than one actuator. The plurality of sensors 12 allow to measure multiple response indicators. The systems therefore allow a multiple-input-multiple-output, MIMO, analysis.

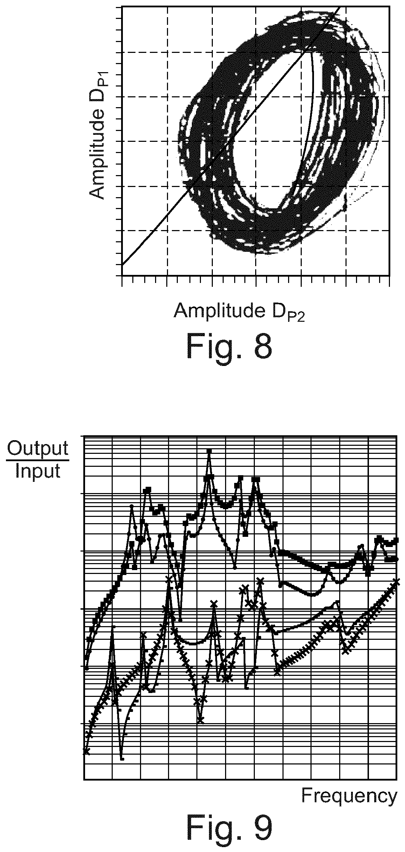

Figure 8 shows the position of the centerline of the shaft 100 as measured by the sensors 12 DP1 and DP2 shown in Figure 6 over a period of time. As can be seen, the centerline describes an orbiting motion. The magnitude of this orbiting motion may be indicative of a defect in the machine 10D. Thus, a parameter describing the orbiting motion, e.g., a frequency, an eccentricity, a radius or the like, or, more generally, a parameter describing the position of the centerline of the shaft, may be used by the diagnosis system 13 as measured response indicator to perform a diagnosis of the machine 10D.

Figure 9 shows ratios of measured response indicators divided by an excitation input versus frequency. Deviations over time at single or multiple sensor locations may indicate a defect in a respective location.

The operational condition of the system 1A, 1B may be defined by a state vector in a k-dimensional space. Each dimension corresponds to one of the relevant dynamic parameters, setting of performances regulation, electronics parameters such currents and voltages, aircraft regulations, e.g., flap, weight, bank angle and/or flight conditions.

The time at which any of the measures is taken may therefore completely characterized only by a k-dimensional vector that, e.g., defines the minimum quantities that are necessary to unequivocally identify an operational performance point of the machine, as on the aircraft. Therein, k is the number of operating parameters and response indicators that are included in the state vector.

For a hybrid electric machine, the status vector may include: dynamic parameters, shaft speeds, torque levels, propeller pitch angles, propeller axis orientation, power levels, variable vane angles, fuel specific consumption, temperatures, pressures, voltage levels, current levels, battery levels, flight altitude and/or bank angles. This state vector is therefore defined for each instant of time at which the self-diagnostic multi-input excitation multi-output diagnostic analysis is being actuated.

A fleet data base may be comprised by the system 1A, 1B to store the relevant flight and/or maintenance (grounded) acquired conditions that are characterized by the above defined k-dimensional state vector.

To facilitate the identification of the severity of variation trends in one or more mechanical or electrical response indicator the k-dimensional vector may be be associated to a two-times-k-dimensional vector that defines nominal intervals (ranges) for each of the parameter contained in the state vector. This vector represents a nominal state vector. It is worth noting that this 2k-dimensional vector that defines the allowable range for each parameter in the state vector is in turn a function of speed, power, flight conditions etc. Further it can vary versus time (e.g., to account for higher clearances that are caused by wear and tear accumulated during flight missions). The upper and lower extremes of the nominal intervals contained in the 2k-dimensional range vector represent alarm values for each parameter (optionally, warning and not-to-exceed alarms are defined within the nominal state vector). The diagnosis system 13 may use the state vector and/or the nominal state vector for diagnosis.

For example, the number of dimensions of the state vector is defined so as to unambiguously describe the state of the machine, e.g., system performance conditions, dynamic conditions, voltages and currents.

Notably, the response of the system is determined by forces and moments that are generated in a mechanical domain (which includes dynamics, aerodynamics, materials, thermal properties etc.) and by electromagnetic fields/forces of an electromagnetic domain. These two domains interact each other (in a cross domain) and this interaction is expected to affect the response of the system, which therefore will not be the simple sum of the mechanical and electrical response. The diagnosis system 13 is adapted to detect a variation of the state vector.

The state vector may comprise one or more speeds, one or more temperatures, one or more pressures, an altitude, one or more derivatives of any of the parameters and/or one or more gradients, of any sensor-measured response indicator in the field of differently located sensors.

Frequency response functions translate forcing functions due to the excitation (electromagnetic forces, controlled impulses by movable parts, e.g., propellers, a variable geometry nozzle etc., or due to operations, e.g., an unbalance, lightning, gusts etc.) into a system response (a response of the mechanical system components, a response of the electrical system components, a response of the controllers and a response in cross-domains which can be non-linear). All responses may be compared with the nominal state vector defining nominal limits for all parameters.

A possible consequence if the diagnosis system 13 detects a fault, is e.g., the avoidance of a specific speed range until the next maintenance.

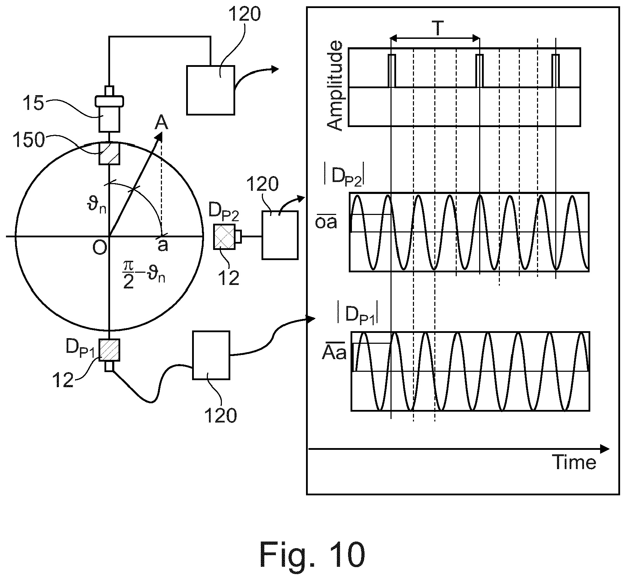

Figure 10 shows a keyphasor 15 of the machine 10D, however, any of the machines herein may comprise such a keyphasor 15. The keyphasor 15 provides a phase reference. Specifically, the keyphasor 15 detects a target 150 fixedly mounted on any rotating element E of the machine 10D. The signal provided by the keyphasor 15 is shown on the right side of Figure 10. At constant speed of the shaft 100 it provides impulses at regular time intervals. The distance between two intervals corresponds to one turn of the shaft 100. The target impulse serves as an angular reference. The positions of the pulses of the keyphasor 15 along the x axis (upper diagram) provide the corresponding phase angles. The other two sensors 12 are distance probes to measure an orbit of the rotating element. The amplitudes of these two sensors 12 are illustrated in the middle and lower diagrams. The amplitudes of these two sensors 12 may be analyzed by the diagnosis system 13.

The diagnosis system 13 is adapted to determine a phase of a measured response indicator with respect to the phase reference, wherein the diagnosis system 13 is adapted to determine a phase shift between the phase of the measured response indicator with respect to the phase reference, and a baseline (e.g., a previous measurement).

Notably, the analysis unit 13 may use the keyphasor 15 target 150 as reference for a phase analysis. Alternatively, the phase of the excitation input may be used by the analysis unit 13 as phase reference (e.g., for comparison with a measured response indicator).

In general, the diagnosis system 13 may determine a vibration vector defined by magnitude, direction, phase angle and frequency.

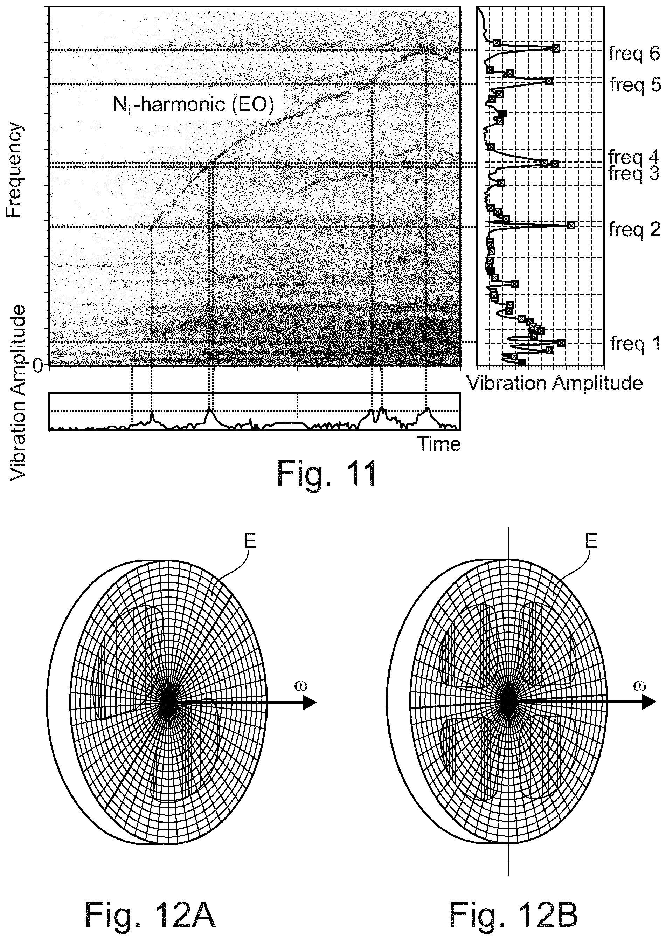

Figure 11 shows a frequency spectrum measured with one of the sensors 12 versus time. Several lines can be seen that correspond to the speed of the shaft and multiples (engine orders, EO) thereof. It can be seen that specific frequencies are particularly pronounced. The diagnosis system 13 may perform a frequency analysis of the measured response indicators. The diagnosis system 13 may perform a Fourier analysis. The frequency spectra obtained with excitation may be compared to spectra obtained without excitation or with the same excitation at another location and/or time and/or at the same or similar defined conditions. Differences may indicate a defect.

Figure 12A and 12B show two examples of different mode shapes of the rotating element E (in this example generally having the shape of a disc).

For a dynamical system, a mode is a standing wave state of excitation, in which all parts of the system will be affected sinusoidally under a specified fixed frequency. A mode of vibration is characterized by a modal frequency and a mode shape. Given a certain component (in particular a rotating element E of the machine), a mode shape corresponds to a characteristic deformation at which the component vibrates when one of its natural frequencies is excited. The vibratory response of the component corresponds to a linear combination of all mode shapes.

The mode shape shown in Figure 12A has two upward deformations and two downward deformations (i.e., each two maxima and minima). The mode shape shown in Figure 12B has four maxima and four minima.

Optionally, a predefined mode shape is excited for analysis of the response, e.g., it is known to be critical.

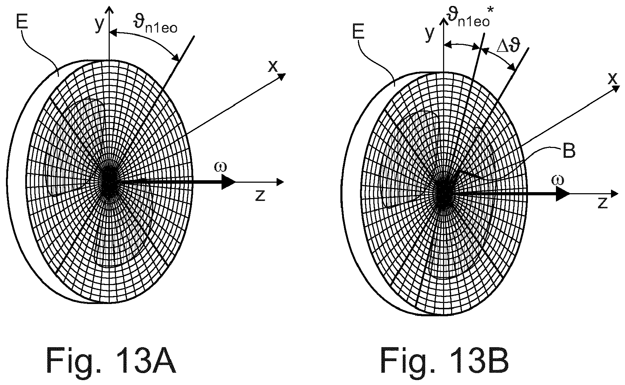

Figures 13A and 13B show the application of a mode shape for diagnosis.

A rotating element E of the machine 10D is excited to vibrate in a predetermined mode by means of the exerted excitation (e.g., using a piezo element as actuator). The mode shape is measured, e.g., by means of an axial sensor 12 and/or using a sensor detecting reflected light. Without a defect in the rotating element E, the mode shape rotates at the speed of the shaft 100 (at the first engine order), see Figure 13A. The sensor 12 detects the passing of a characteristic point or line, namely, the portion between the two alternating deflections indicated by a line and with an angle.

When the rotating element E has a defect, however, such as a crack, the mode shape will be altered and the characteristic point/line will be detected at a different angular position with respect to a fixed point on the rotating element E, as indicated in Figure 13B with delta theta.

Using the phase reference provided by the keyphasor 15, this phase shift can be precisely measured. Measuring this phase shift allows to determine a defect in the rotating element E, which might be any rotating part of the machine 10D.

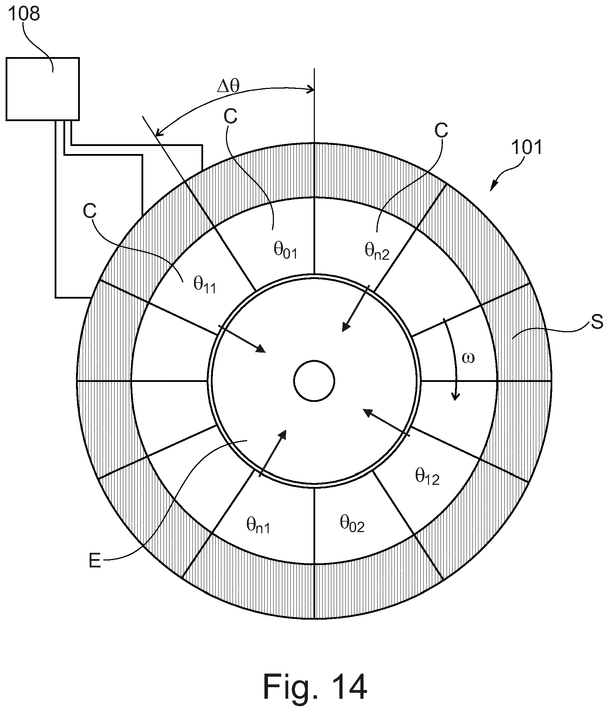

Figure 14 shows the electric motor 101 of the machine 10D (however, any of the machines herein may comprise such an electric motor 101) with an outer stator S and an inner rotor (rotating element E). While Figure 14 shows the rotor with its geometric center coaxial with the geometric stator center, an air gap between the rotor and the stator allows an eccentric arrangement. In an eccentric arrangement a clearance between the rotor and the stator S is non-uniform.

The stator S has a plurality of coils θ01-θn1, θ02-θn2 to drive the rotor (that may have permanent or electric magnets).

Unbalanced magnetic pull is usually associated with non-uniform induction due to winding faults or rotor eccentricity conditions. Due to a non-uniform clearance, the magnetic flux in the air gap is also non-uniform and this can be measured by a sensor 108 connected to the coils θ01-θn1, θ02-θn2 and/or to a control system of the electric machine 10D so as to receive signals therefrom. For example, magnetic induction in the coils θ01-θn1, θ02-θn2 may be measured, e.g., by measuring voltages and/or currents at the coils θ01-θn1, θ02-θn2. For example, pairs of opposing coils θ01-θn1 and θ02-θn2 may be compared by the sensor 108.

Thus, the sensor 108 can detect an unbalance of the rotor. However, since the electric motor 101 is operatively connected to other parts of the driveline of the machine 10D shown in Figure 5, it is also sensitive to unbalances from rotatable components of the driveline. Thus, the sensor 108 can be used as a vibration sensor. Since it may directly sense vibrations in the driveline, rather than by means of external sensors, a particularly high precision is possible without the need of further sensors. To this end, the sensor 108 may provide signals indicative for the unbalanced magnetic pull as response indicator to the diagnosis system 13, or it may pre-process unbalanced magnetic pull signals and provide processed signals, e.g., frequency spectra, as response indicator(s) to the diagnosis system 13.

Arrows indicate characteristic portions of an excited mode shape which is depicted schematically.

In turn, the electric motor 101 may serve as an actuator as described above.

The exerted excitation may also be used to de-ice the machine, propeller or other part of the system 1A-1B.

The system 1A-1C is able to detect, in an early manner, electrical drifts in the power electronics or loss of stability in the engine controllers, as well as early signs of mechanical degradation of some of the critical mechanical components of the aircraft. The ability to detect anomalous conditions in the engine at an early stage is also beneficial to avoid the loss of performance related to gradual changes, e.g., in the gap between rotors and stators of an electrical machine, that would remain otherwise undetected until the deterioration further progresses. Examples for parameter drifts that may be detected with the systems and methods described herein are: permanent magnet flux linkage, motor inductances, power switches R_ds,on, switching behavior, symmetry, DC link capacitance, resistance, Battery internal resistance, and inductance.

Some of the parameter variations in the system response can be related to early cracks, increased misalignments, loss of balance, bearing damage, loss of tightening of bolted junctions, wear and tear or out-of-nominal conditions in couplings, initiation of cracks in rotors or in the fuselage etc.

One possible function of the diagnosis system 13 is to determine a variation of the position of the centerline of one or more rotors of the machine with respect to defined rotating and static parts. This is defined by three coordinates xyz of the center of the rotor and three angles to define misalignment or torsion angle. The centerline can oscillate or orbit, including (radial and/or axial) bouncing (harmonic or transient) movements as degeneration of orbits, including bouncing in axial direction. It may be noticed that the centerline can move at several frequencies due to vibration contemporaneously acting on the rotor.

Another possible function of the diagnosis system 13 is to determine a variation of a stiffness ratio, both total stiffnesses and modal stiffnesses, between different defined locations and/or in different xyz directions or rotations. It is worth noting that this characterization may use the measure of the identification (and shift) in natural frequencies to estimate a stiff variation that can be related by mean of calculations or FEM simulation to a change in the stiffness in the modal stiffness of one or more components.

Another possible function of the diagnosis system 13 is to determine the variation of the vibration vector in xyz in one location or across different locations. The vibration vector in one direction is defined by a module, a frequency and a phase. The phase of a vibration spectral component, or vibration component vector, is very sensitive to local variation in the modal stiffness of the rotor, which is in turn related to defined mode shapes of the rotor. For this reason, measuring the phase shift of certain vibration components, it is possible to detect a crack also of relatively small dimensions.

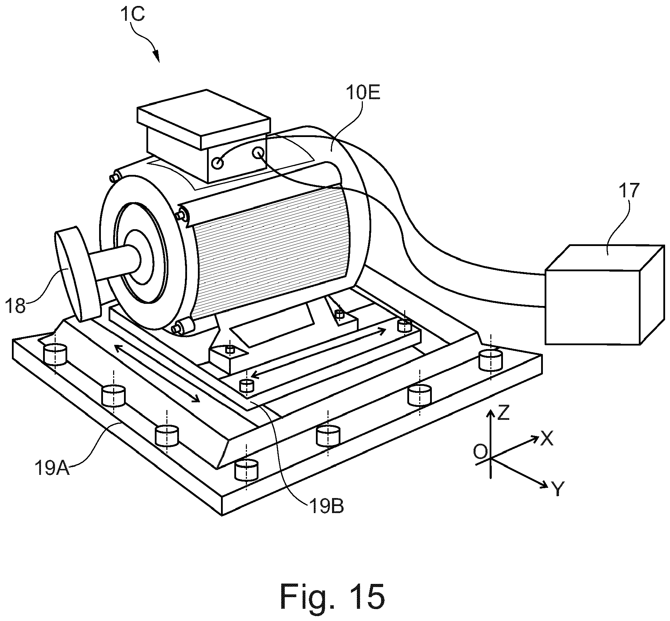

Figure 15 shows a system 1C for diagnosis of an external device. The external device, which might be an aircraft engine, may be operatively connected by means of a coupling, such as flexible coupling 18. The system 1C comprises a machine 10E which may be designed as one of the machines described herein, e.g., as machine 10D according to Figure 5. For simplicity, other components of the system 1C are not depicted in Figure 15, but present, such as the controller 11, sensors 12 and diagnosis system 13.

The machine 10E is mounted on the ground by means of a 2-dimensional alignment system 19A, 19B which may be a rails-bolts system. The alignment system 19A, 19B allows to align the machine 10E to the connected external device in the horizontal plane. A vertical alignment may be made using the flex coupling 18 and/or shimmers.

The system 1C may be used to perform DO160 tests.

The machine 10E is dedicated to providing controlled excitations to both rotating components and to power electronics components 17 that are electrically connected to it. The machine 10E can be used to exert radial and axial forces on the shaft, in addition to a torque modulation and tangential forces that the electric motor of the machine 10E can supply.

An advantage of this system 1C is the capacity to excite at the same time power electronics and rotating mechanical components of external devices under test with the excitation types described above. This allows to test a cross domain reaction to a number of several failure cases that can happen in flight or during the mission of the hybrid/electrical power plant (e.g., in an automotive application, a wind power plant, marine power plan, helicopter etc.).

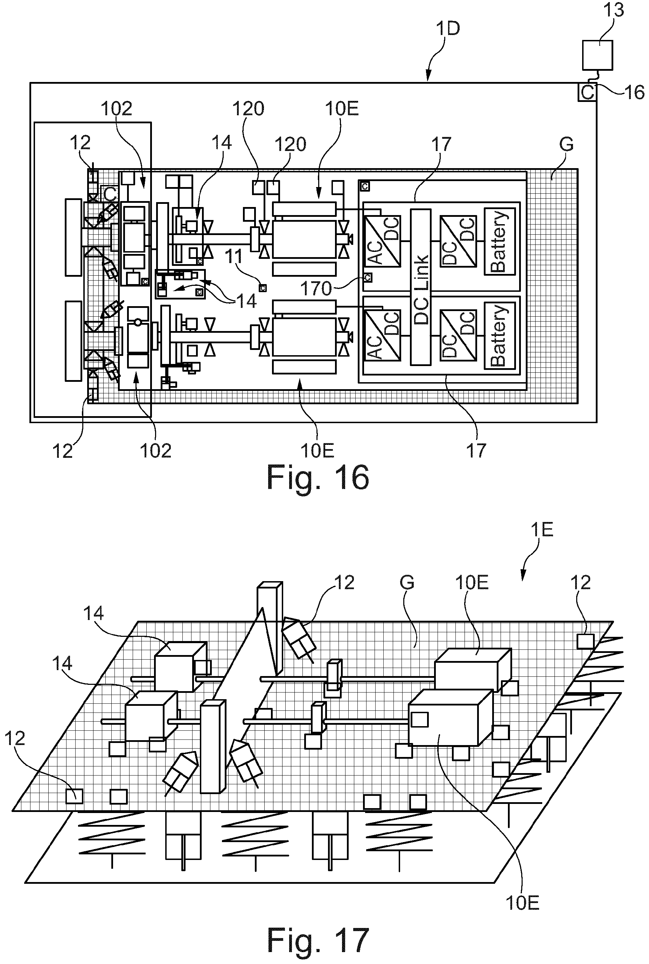

Figure 16 shows a system 1D similar to the system 1C of Figure 15. The system 1D may comprise the system 1C. Specifically, the system 1D comprises more than one machine 10E, in this example two electric machines 10E. For the ease of illustration, the machine 10E and its driveline shown in the upper part of Figure 16 is shown in more detail than the lower one for the ease of illustration, but both may comprise identical components.

Each machine 10E is provided with electrical power by respective power electronics 17. In this example, each power electronics 17 comprises a battery and a DC-DC converter. The DC-DC converters are connected to a common DC link (optional). Further, each power electronics 17 comprises a DC-AC inverter which supplies alternating current to the respective machine 10E. The DC-AC inverters are supplied with DC power from the DC link. Each power electronics 17 comprises a controller 170. The controller 170 controls the electrical power supplied to the respective machine 10E. For example, the power electronics 17 may superimpose an excitation on sinusoidal alternating currents, e.g., a excitation in to form of one of the excitations shown in Figures 7A-7G.

As described above, the machines 10E, and components in the driveline of the respective machine 10E, comprise various sensors 12 and respective data acquisition modules 120 (only some of which being shown for illustration). For example, sensors are arranged at bearings of the shaft of each of the machines 10E. Further, several actuators 14 are provided for each machine 10E. The actuators 14 are adapted to exert radial, axial and tangential forces on the drive train (alternatively, or in addition, on a frame supporting the machines 10E and/or their drivelines). Thus, depending on the excitation to be exerted, the actuators 14 may be controlled (by respective controllers, each being indicated with a box labelled with a "C") to selectively exert radial, axial and/or tangential forces.

Rectangles in Figure 16 indicate which components of the system 1D are controlled by a respective controller indicated by boxes labelled with a "C". Hence, each power electronics 17 comprises a controller 170. The plurality of power electronics 17 (two in this case) is controlled by a controller which controls the individual controllers 170. The actuators 14 are controlled by respective controllers. Each machine 10E is controlled by a controller 11 as described above. Further, the overriding controller 16 controls at least the machine 10E controllers 11, in particular, all controllers (directly or in directly via other controllers).

Notably, a grid G is defined in a two-dimensional plane or in a three-dimensional space. Some or all of the components of the system 1E have specified positions on the grid G. The grid G may also allocate and serve to measure input and output at the interfaces, such as the load transmitted from module to module and form module to frame (rig platform or aircraft platform (frame)). In particular, the positions of the sensors 12 on the grid G are defined and, e.g., stored in one or more of the controllers (e.g., the overriding controller 17; input and output of the controller loops may also be included). In the present example, the positions are stored in the diagnosis system 13. Presently, also the positions of the actuators 14 and of the machines 10E on the grid G are stored in the diagnosis system 13 (alternatively, or in addition, in one or more of the controllers, such as the overriding controller 17).

The grid G may be used as a geometrical reference with ping points and measure points. The grid G may be used as a diagnostic grid together with the state vector which may include the points on the grid G.

Thus, when exerting an excitation at a predefined location on the grid G, the sensors 12 located at various positions on the grid G may sense a response at different times. The diagnosis system 13 is adapted to determine the propagation of an excitation over the system 1D based on the response indicators measured by the sensors 12. This allows to discern different possible defects of one or more machines to be tested connected to the system 1D (e.g., via a clutch or flange coupling).

Using the two machines 10E, the system 1D may exert excitations with each of the machines 10E with an offset in time. Alternatively, or in addition, different excitations may be exerted with the two machines 10E at the same time.

Figure 17 shows (in a more simplified manner) a system 1E similar to the system 1D shown in Figure 16. Here, a two-dimensional grid G is defined, and two machines 10E, actuators 14 and respective shafts are illustrated, supported by a support structure. Further, numerous sensors 12 are arranged at different locations on the grid G, more particularly, distributed over the grid G. All these components are mounted on a planar support, which is supported on a base by support elements having an adjustable stiffness (indicated with the spring constant k). The support elements may exert non-contact forces, e.g., magnetic forces. Actuators and/or sensors below the planar support are adapted to exert forces on the planar support and/or to measure a movement of the planar support with respect to the base.

This dynamic grid G may provide adaptive non-contact stiffness modifications, controlled movements of the system actuators and/or mistuning of integer speed ratios.

The various sensors 12 having defined locations on the grid G provide response indicators that may be analyzed to determine the propagation of an excitation over the grid G. As described above, this allows to discern different possible defects of one or more machines to be tested connected to the system 1E.

Notably, the grid G may also be defined in any other system described herein, e.g., on the aircraft 2 of Figures 1-3.

From the excitation (which may also be referred to as ping) and the measured response (e.g., including drifts of measured parameters), the diagnosis system 13 may extract diagnostic information, generate active compensations at the locations of the ping excitations and send instructions to other controllers (indicating a determined efficiency loss, vibration, controller non-linearity and/or AC systems reaction).

With reference to Figures 16 and 17, it is worth noting that it is possible that a measure of a generalised load and vibration transmitted is stored, e.g., in the diagnosis system 13, in the directions defined by the load path, e.g., at the static and/or dynamic interfaces. Further, the one or more actuator(s) may be adapted to simulate modulations, loads and/or relative displacements that are expected to be transmitted at one or more of the interfaces of the system.

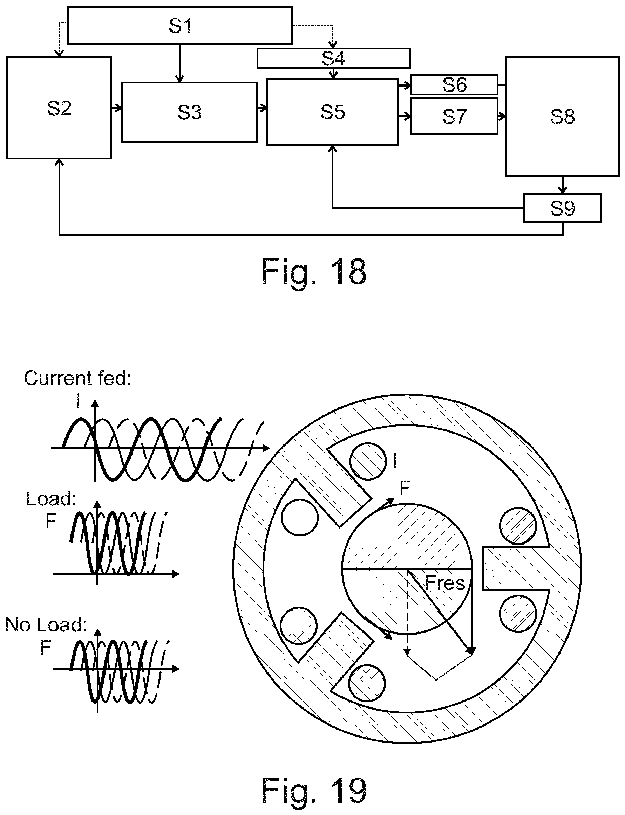

Figure 18 illustrates a method of operating a system, such as one of the systems described herein.

In step S1, at least one machine 10A-10E (optionally, a plurality of machines) is operated. The operation may be in accordance with a predefined operating condition, such as start-up, taxi-out, take off, initial climb, limb, cruise, descent, approach, landing or taxi in. The defined condition may also be an inactive condition such as stand still, however, according to an embodiment, the defined condition may be defined as an active condition where at least one machine 10A-10E is active, and in this case stand-still would be excluded. The defined condition is described by at least one operating parameter, such as one or more components of the state vector described above.

Step S1 further comprises controlling at least one actuator so as to exert an excitation of the machine 10A-10E and/or to detect a predetermined excitation of the machine 10A-10E, the excitation being superimposed to the defined condition of the machine 10A-10E. The at least one machine 10A-10E may serve as the actuator. Alternatively, or in addition, a device different from the machine 10A-10E may be used, such as a magnetic bearing or a vibrator.

In step S2, at least one response indicator of a response of the machine 10A-10E to the excitation is measured by means of at least one sensor 12, 108. Further, the parameters of the state vector are recorded. These parameters include performance parameters, control parameters, mechanical parameters, electromagnetic parameters (in particular, AC parameters), and parameters of the excitation. The excitation may serve as a ping. The excitation may be referred to as a ping excitation.

In step S3, a variation of the state vector versus time may be determined. For example, a derivative of each parameter of the state vector may be determined. Further, gradients on the grid G may be determined.

In step S4, a state vector target may be defined and/or provided. Depending on the current defined condition, a certain state vector may define an energy efficient operation of the system.

In step S5, the diagnosis system 13 receives the at least one measured response indicator and the at least one operating parameter. More specifically, the diagnosis system 13 receives the state vector and, optionally, the state vector target. The diagnosis system 13 may perform a conventional analysis of the received data by determining the excitation and the effect of the excitation. Alternatively, or in addition, the diagnosis system 13 may determine covariances in a multi-dimensional space. Further alternatively, or in addition, an artificial intelligence module 130 may be used to analyze the data, e.g., to recognize patterns in the data.

In step S6, the diagnosis system 13 may perform diagnostics, e.g., based on the determined effect, covariances and/or patterns. For example, specific pre-defined effects, covariances and/or patterns may indicate a specific defect or wear. In step S7, the diagnosis system 13 may optionally identify key functional influences. This may be used for improving the operation of the system.

In step S8, corrective actions may be performed based on the diagnostics and/or identification of the key functional influences. For example, a performance and/or safety level may be maintained. A cost reduction may be obtained, e.g., by improving the efficiency of the system, for example by reducing vibrations. A service disruption reduction may be obtained, e.g., by determining a wear of a certain component which could then be exchanged even before developing a defect. In a similar manner, maintenance may be optimized based on the improved knowledge on the condition of the system. In addition, the results of the diagnosis system 13 may also be used for optimizing the design of the system. Further, active vibration (and noise) reduction may be performed, e.g., using various iterations of excitations and the determination of the response.

In step S9, a benefit assessment may be performed, e.g., by the diagnosis system 13. Based on this assessment, a cost reduction may be performed. For example, the selection of sensors for the analysis may be improved and fed back to the next iteration of step S2. For example, if it is determined that a certain sensor is not significant for a certain observable, it may be excluded from the next analysis. Further, the result of the assessment may be fed back to the next iteration of step S5 in order to improve the diagnosis.

The actuators shown in Figures 19-23 may be used in any of the systems and methods described herein.

Figure 19 shows an actuator that may be used in any of the systems described herein, for example, as an actuator of the system of Figure 5. The actuator of Figure 19 may be used as electric machine to provide thrust and/or as an electric generator. A rotor comprises a permanent magnet and is arranged in a stator having three coils for three phases of an alternating electrical current.

On the left-hand side of Figure 19 three schematical diagrams are shown. The upper diagram illustrates the current fed for the three phases to drive the rotor. The coils may be fed with currents so as to exert forces on the rotor which have opposite direction and/or different amplitudes, for example, as shown by arrows in Figure 19. A resulting force Fres urges the rotor in a direction perpendicular to its rotational axis. The diagram in the middle and the lower diagram show forces exerted by the three coils on the rotor. For example, sinusoidal components may be superimposed by a constant component. The AC force frequency is twice the electrical current frequency and fixed to the rotational speed via the number of pole pairs. Adding an additional rotational field of smaller amplitude with fixed frequency is possible. Signals like this can be used by sensorless control (e.g., a fixed frequency AC injection on d or q components in the rotor fixed coordinate system). Applying a modulated signal on the excitation winding of a rotor can allow to generate specific force vectors.

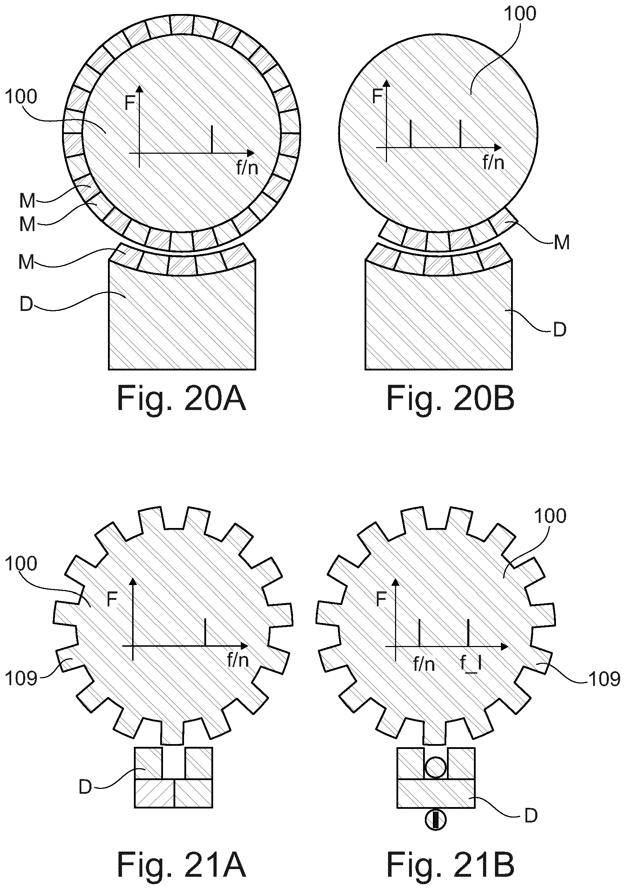

Figure 20A shows another actuator with a rotor (e.g., shaft 100) with a plurality of magnets M on its outer circumference, and a device D having a plurality of magnets M. In the present example, the device is a stator. Both on the rotor and on the stator the magnets M are arranged in the form of Hallbach arrays. Here, the Hallbach arrays are arranged oppositely to one another. An alternating (normal and tangential) magnetic force excitation can be achieved with opposing Hallbach arrays on rotor and stator. Pulsating normal and alternating tangential magnetic force excitation is possible by reluctance. Excitation can be done by pulse modulation or by a DC-excitation coil. The rotation of the rotor with respect to the stator introduces forces with a frequency that depends on the rotational speed of the rotor (as illustrated with a small schematic diagram). The concept is sensitive to airgap length and can be used as sensor as well.

Figure 20B shows a similar arrangement as Figure 20A, however, the magnets M on the rotor do not encompass the rotor over its entire circumference, but only extend over a section of the rotor along its circumference. By this, two different frequencies can be obtained as excitation.

Optionally, the device D is radially movable to enable or disable the excitation. Alternatively, the magnets M on the stator (or on the rotor) may be electric magnets that can be selectively switched on or off.

Figure 21A shows another actuator with a rotor (e.g., shaft 100) having a plurality of teeth 109. The teeth 109 are uniformly shaped. A device D comprising a permanent magnet is arranged besides the rotor (and is, optionally, movable in radial direction). This allows to introduce forces with a frequency that depends on the rotational speed of the rotor.

Figure 21B shows the same concept as Figure 21A, wherein the device D comprises an electric coil (instead of, or in addition to, the permanent magnet). By this, forces with more than one frequency may be exerted.

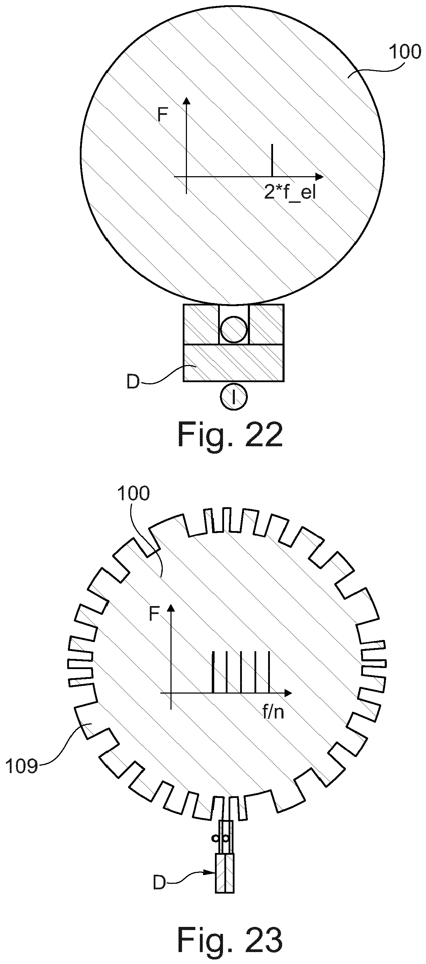

Figure 22 shows a similar concept as Figure 21B, wherein the rotor, however, comprises no teeth. This allows to induce a force depending on the frequency of the current through the coil with a particularly simple setup. Here, the actuator mainly comprises an electric magnet. Electrical excitation and modulation on a isotropic rotor can generate force patterns for various detection methods. As the forces are generated by reluctance, this is sensitive to the airgap length.

The concepts shown in Figures 21B and 22 allow an integrated distance measurement, e.g., by analyzing the current through the coil.

The actuator of Figure 22 may comprise more than one device D, e.g., three or four devices D arranged (e.g., equidistantly) around the circumference of the rotor. This allows to deflect the rotor in any radial direction. The actuator of Figure 22 (and the other actuators described herein) may be controlled by the controller 11 as described above.

Figure 23 shows a rotor (e.g., shaft 100) having teeth 109 with non-uniform shape. More specifically, the rotor has teeth 109 with different widths. Here, the rotor has a plurality of sets of teeth having, from tooth to tooth in circumferential direction, an increasing width. A proper design of such rotor poles can enable the excitation of forces with several frequencies resulting from the rotational speed. The device D in this example has a permanent magnet and a coil.

Table 1 associates, for each of the excitations shown in Figures 7A-7G, main detection features (second column), and further details when used to create mechanic excitations by an electric machine such as a motor (third column), when used to create mechanic excitations by a dedicated actuator (e.g., actuator 102 or 14 or one of the actuators shown in Figures 20A-23) (fourth column), and when used to excitations of electric components by an electric machine 10A-10E such as a motor (fifth column).

For the description of several fields of Table 1, reference is made to the description of Figures 19-23 above as indicated in Table 1.

**Table 1**

| Excitation type | Detection features | Mechanic excitation by el. machine | Mechanic excitation by dedicated actuator | Excitation of electric components by el. machine |
|---|---|---|---|---|
| Figure 7A | A1 | B1 | Figs. 20A-21B | C1 |
| Figure 7B | A2 | Fig. 19 | Figs. 20A-21B | C2 |
| Figure 7C | A3 | B3 | Fig. 22 | C3 |
| Figure 7D | A4 | B4 | Fig. 22 | C4 |
| Figure 7E | A5 | B5 | Fig. 22 | C5 |
| Figure 7F | A6 | B6 | Fig. 22 | C6 |
| Figure 7G | A7 | B7 | Fig. 23 | C7 |

Several individual fields of the table are discussed below.

In the following main detection features obtainable using the different excitation patters are presented:
Detect a broadband excitation to measure the frequency response functions of rotors and/or static frames: A1, A7;
Detect a variation of the frequency magnitude: A1;
Detect modal damping and phase of the peaks with respect to the forcing function: A1;
Detect a variation of vibration parameter ratios across different sensor locations: A1, A2, A3, A4, A7;
Detect a variation of vibration magnitude ratios in XYZ directions: A1, A2, A3, A4, A7;
Detect an excitation of specific natural frequencies: A2, A3, A4;
Detect a variation of peaks, frequency, magnitude and/or phase (forcing function): A2, A3, A4;
Detect a phase variation against a rotating fixed reference: A2, A3, A4;
Detect a modal damping variation: A3, A4;
Detect a dynamic stability of the system: A5;
Detect a variation of the forced response of the system: A5;
Detect a variation of damping: A5;
Detect a drift in the system stability: A5;
Detect a response to a step function: A6;
Detect a variation of the response of the system across different locations/directions: A6.
B1: When the excitation of Figure 7A is exerted with a machine 10A-10E (e.g., motor), force and torque excitation can be done with a transient short circuit; and a permutation in systems with multiple winding systems could generate multiple force vectors.
B3: Superposing an additional rotational field of smaller amplitude with fixed frequency is possible. Signals like this may be used by sensorless control (i.e., fixed frequency AC injection on d or q components in the rotor fixed coordinate system). The amplitude of the excitation signal can follow a predefined trajectory.
B4: See B3. The frequency of the excitation signal can also follow a predefined trajectory.
B5: The pattern of Figure 7E is similar to an intrinsic current ripple. The amplitude of the excitation can be controlled by the switching frequency. A variable switching frequency is possible. However, the correlation of amplitude and frequency is fixed by inductance and DC voltage.
B6: Controlled load drops or load steps can be applied by a modulation of the reference values for the current controller. Alternating steps (breaking, accelerating) will typically create the highest excitation. Permutation in systems with multiple winding systems could serve as internal reference for the rotor angle (or speed) response.
B7: Random excitation can be generated by usage of hysteresis current control (enabled either by fast current sensor or observer).

With respect to the fifth column of Table 1, the indicated excitation pattern can be applied to the machines 10A-10E in the form of electric motors in the systems and methods described herein.
C1: Swap the energy from the magnetic field into the DC link capacitors and check the capacity: 1. create currents in the AC system, 2. switch to SSO (six switches open), 3. the currents will commutate via the diodes on the DC link, 4. monitor the DC voltage curve, 5. estimate the DC capacity from the known currents and AC inductance.
C2: 1. Apply of a pulse pattern for a symmetrical voltage system and check the symmetry of the AC current response to detect: - Inductance variation in the machine, i.e. by short circuit, - faults in the power switches, driver stage, etc., - apply higher currents and check symmetry of power switches temperatures, - detect faults in one of the parallel chips/dies; Monitor the auxiliary power demand of the driver stage/electronics. 2. Use a DC link pre-loading phase when the DC voltage is not yet fully up to measure the parasitic capacity in the AC system to detect a variation of capacities, inductances and/or resistances.
C4: Monitor a current ripple in the AC side and check correlation with a voltage ripple on the DC-capacitors. A variation of switching frequency allows further characterization (and monitoring) of the AC characteristics.
C5: Monitor a current ripple in the AC side and check correlation with voltage ripple on the DC capacitors.
C7: Generally, observers for electronics can be used as a reference for all internal temperatures, powers, voltages and/or currents. The excitation can be random. Calibration of the observer may be performed for these signals. This could be done by self-tuning and intrinsic consideration of the signal processing.

It is worth noting that systems described herein may be adapted to provide defined voltage and current excitations and/or defined load and moments excitations. By this dual functionality both the mechanical and electrical systems and controls may be excited and a diagnosis thereof may be performed.

Further, the systems described herein may be adapted to actively mistune and/or control vibrations. For instance, by means of the excitations the modal stiffness of the mechanical assembly (e.g., the structure and/or rotors) may be adaptively changed using non-contact stiffness generated from the machine(s) 10A-10E (which may be exerted in terms of electromagnetic forces and moments). To provide an example, this may be used to mistune torsional and axial resonances in a shaft connected to an electric machine.

Further, the systems and methods described herein may be used to simulate extreme operational conditions and failure cases (e.g., electromagnetic-thermal-mechanical cross domains), and to enhance signal to noise ratios.

It will be understood that the invention is not limited to the embodiments above-described and various modifications and improvements can be made without departing from the concepts described herein. Except where mutually exclusive, any of the features may be employed separately or in combination with any other features and the disclosure extends to and includes all combinations and sub-combinations of one or more features described herein.

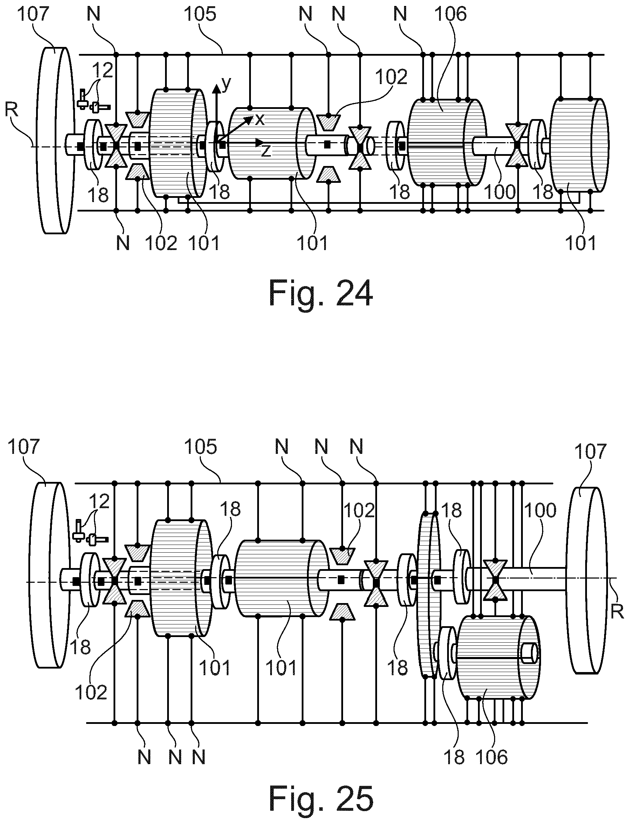

Figures 24 and 25 show similar systems as the system 1B shown in Figure 5.

According to Figure 24, two electric motors 101 are operated in series with one another via a flex coupling 18, and with a turbomachine 106 via another flex coupling 18. The latter flex coupling 18 may engage or disengage the turbomachine 106 from the electric motors 101. The turbomachine 106 is operated in series with a third electric motor 101 via another flex coupling 18. These electric motors 101 und turbomachine 106 are coupled with a rotating element 107 via another flex coupling 18. A casing 105 is illustrated and the connection of the various components with the casing 105. The interface load paths from the respective component to the casing 105 are illustrated by lines. These interface load paths are connected to the casing at nodes N. The components may or may not have shock absorbers. The diagnostic system 13 may base the analysis of the response indicators on the load path of one or more of the components of the system and/or on the location of a node N (or relative location of two nodes N).

Figure 25 shows a similar system to Figure 24, wherein two electric motors 101 are provided and a turbomachine 106 is operatively connected in parallel via a clutch, belt, plate and/or transmission (e.g., a variably geared transmission box).

The nodes N may constitute nodes of the grid G.

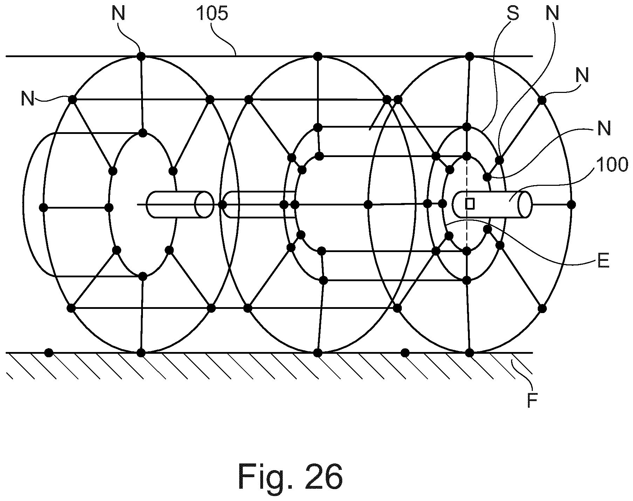

Figure 26 shows a schematic 3d illustration of an electric machine having a stator S fixedly connected to the casing 105 (and, via the casing 105, to the frame F) and a rotating element E as a rotor fixed to a shaft 100 as well as an optional coupling to further components. As illustrated, the grid G having the nodes N may be defined in three dimensions. The grid G may also comprise nodes N which have a load path via electromagnetic interactions, such as between the stator S and the rotating element E. Notably, the nodes N may generally be defined with 6 degrees of freedom, i.e., with three location parameters and three rotation parameters.

### List of reference numbers

- 1A-1E: system
- 10A-10E: machine
- 100: shaft
- 101: electric motor / actuator
- 102: magnetic bearing / actuator
- 103A, 103B: propeller
- 104: bearing
- 105: casing
- 106: turbomachine
- 107: rotating component
- 108: sensor
- 109: tooth
- 11: controller
- 12: sensor
- 120: data acquisition unit
- 13: diagnosis system
- 130: artificial intelligence module
- 131: memory
- 14: actuator
- 15: keyphasor
- 150: target
- 16: overriding controller
- 17: power electronics
- 170: controller
- 18: flex coupling
- 19A, 19B: alignment system
- 2: aircraft
- 20: energy storage
- 21: gas turbine engine
- 22: generator
- 23: power electronics
- B: crack
- C: coil
- D: device
- E: rotating element
- F: frame
- G: grid
- M: magnet
- N: node
- R: rotational axis
- S: stator

## Claims

1. A system (1A-1E), comprising:
- a machine (10A-10E) being operable in a defined condition described by at least one operating parameter;
- a controller (11) adapted to control at least one actuator (101, 102, 14) so as to exert an excitation of at least a part of the system (1A-1E), in particular of the machine (10A-10E) and/or to detect a predetermined excitation of at least a part of the system (1A-1E), in particular of the machine (10A-10E), the excitation being superimposed to the defined condition of the machine (10A-10E);
- at least one sensor (12, 108) to measure at least one response indicator of a response of at least the part of the system (1A-1E), in particular of the machine (10A-10E) to the excitation; and
- a diagnosis system (13) adapted to receive the at least one measured response indicator and the at least one operating parameter.

2. The system (1A-1E) according to claim 1, further comprising a keyphasor (15) providing a phase reference, wherein the diagnosis system (13) is adapted to determine a phase of the measured response indicator with respect to the phase reference, wherein the diagnosis system (13) is adapted to determine a phase shift between the phase of the measured response indicator with respect to the phase reference, and a baseline.

3. The system (1A-1E) according to any of the previous claims, wherein the diagnosis system (13) is adapted to combine the at least one measured response indicator and the at least one operating parameter into a state vector, and to compare the state vector with another state vector acquired at a different time and/or system.

4. The system (1A-1E) according to any of the previous claims, comprising a plurality of sensors (12, 108) to measure response indicators, wherein the diagnosis system (13) is adapted to determine which one or more of the response indicators varies in response to the superimposed excitation.

5. The system (1A-1E) according to any of the previous claims, comprising a plurality of sensors (12, 108) at different locations of the machine (10A-10E), wherein the diagnosis system (13) is adapted to calculate a ratio of the response indicators measured by means of sensors (12, 108) at different locations.

6. The system (1A-1E) according to any of the previous claims, wherein the diagnosis system (13) is adapted to determine covariances of one or more response indicators and one or more operating parameters to perform a diagnosis of the system (1A-1E).

7. The system (1A-1E) according to any of the previous claims, wherein the diagnosis system (13) comprises an artificial intelligence module (130) to determine one or more correlations in one or more response indicators and one or more operating parameters to perform a diagnosis of the system (1A-1E).

8. The system (1A-1E) according to any of the previous claims, wherein the diagnosis system (13) is adapted to determine a vibration, and to provide a command to the controller (11) so as to control at least one actuator (101, 102, 14) to exert an excitation of the machine (10A-10E) based on the determined vibration, and/or to determine a position of a centerline of a shaft (100) of the machine (10A-10E).

9. The system (1A-1E) according to any of the previous claims, wherein the controller (11) is adapted to control the at least one actuator (101, 102, 14) so as to exert an excitation of the machine (10A-10E), the excitation being periodical, a single impulse, a sweep or a rectangular function, wherein the diagnosis system (13) is adapted store a type of the excitation of the machine (10A-10E) together with the at least one measured response indicator and the at least one operating parameter in a memory (131).

10. The system (1A-1E) according to any of the previous claims, wherein the at least one measured response indicator is or comprises an electrical parameter of power electronics (17), of the controller (11) and/or of another control unit of the machine (10A-10E).

11. The system (1A-1E) according to any of the previous claims, wherein the diagnosis system (13) is adapted to determine a ratio of a response indicator and the excitation in a frequency domain.

12. The system (1A-1E) according to any of the previous claims, wherein the actuator (101, 102) is configured to generate non-contact forces on the machine (10A-10E) to exert the excitation.

13. The system (1A-1E) according to any of the previous claims, wherein the at least one sensor (12) comprises a proximity probe, an accelerometer or a strain gauge, and/or wherein the machine (10A-10E) comprises an electric motor (101) and/or generator having a plurality of coils, wherein the at least one sensor (108) is adapted to receive signals indicative for and/or based on differences among voltages and/or electrical currents of the plurality of coils, and to determine a vibration of a shaft (100) of the machine (10A-10E) using the signals.

14. The system (1A; 1B) according to any of the previous claims, comprising an aircraft (2), wherein the machine (10A-10D) is an engine of the aircraft (2), wherein the detected predetermined excitation of at least the part of the system (1A; 1B), in particular of the machine (10A-10D), is a cross wind.

15. The system (1C-1E) according to any of claims 1 to 13, further comprising an alignment system (19A, 19B) for aligning and fixedly mounting the machine (10E) on the ground.

16. A method, comprising:
- operating a machine (10A-10E) of a system (1A-1E) in a defined condition described by at least one operating parameter;
- operating a controller (11) to control at least one actuator (101, 102, 14) so as to exert an excitation of at least a part of the system (1A-1E), in particular of the machine (10A-10E), and/or to detect a predetermined excitation of at least a part of the system (1A-1E), in particular of the machine (10A-10E), the excitation being superimposed to the defined condition of the machine (10A-10E);
- measuring, by means of at least one sensor (12, 108), at least one response indicator of a response of at least the part of the system (1A-1E), in particular of the machine (10A-10E), to the excitation; and
- receiving, by a diagnosis system (13), the at least one measured response indicator and the at least one operating parameter.
